# EUROPEAN PATENT APPLICATION

(11) **EP 2 778 210 A1**
(43) Date of publication of application: **17.09.2014**
(21) Application number: 14156850.1
(22) Date of filing: 26.02.2014
(51) Int. Cl.: C09K 11/77, H01L 33/50

(54) **Fluorescent substance and light-emitting device employing the same**

(30) Priority: 15.03.2013 JP 2013054006
(71) Applicant: Kabushiki Kaisha Toshiba, Tokyo 105-8001 (JP)
(72) Inventor: Okada, Aoi, Minato-ku, Tokyo 105-8001 (JP); Kato, Masahiro, Minato-ku, Tokyo 105-8001 (JP); Albessard, Keiko, Minato-ku, Tokyo 105-8001 (JP); Fukuda, Yumi, Minato-ku, Tokyo 105-8001 (JP); Mitsuishi, Iwao, Minato-ku, Tokyo 105-8001 (JP); Hattori, Yasushi, Minato-ku, Tokyo 105-8001 (JP)
(74) Representative: Granleese, Rhian Jane

(57) **Abstract**

The embodiment of the present disclosure provides yellow luminescent substance having high luminous efficiency. This fluorescent substance is represented by the formula (1):

(M₁₋ₓREₓ)_{2y}Al_{z}Si_{10-z}OᵤN_{w}Cl_{α} (1)

(in the formula, M is at least one element selected from the group consisting of Ba, Sr, Ca, Mg, Li, Na and K), and it emits luminescence with a peak within 500 to 600 nm when excited by light of 250 to 500 nm.

## Description

### CROSS-REFERENCE TO RELATED APPLICATIONS

This application is based upon and claims the benefit of priority from the Japanese Patent Application No. 2013-054006, filed on March 15, 2013, the entire contents of which are incorporated herein by reference.

### FIELD

Embodiments of the present disclosure relate to a fluorescent substance usable for light-emitting devices, a light-emitting device employing that substance, and a method for producing the fluorescent substance.

### BACKGROUND

A blue LED and a yellow light-emitting fluorescent substance Y₃Al₅O₁₂:Ce³⁺ (YAG) were combined to develop a white LED, and since then various studies have been made on the applications thereof for lighting instruments, backlight sources of liquid crystal displays and the like.

### BRIEF DESCRIPTION OF THE DRAWINGS

Figure 1 shows a vertical sectional view schematically illustrating a light-emitting device employing a fluorescent substance according to the embodiment.
Figure 2 shows an emission spectrum of the fluorescent substance obtained in Example 1.
Figure 3 shows an absorption spectrum of the fluorescent substance obtained in Example 1.
Figure 4 shows an emission spectrum of the fluorescent substance obtained in Example 2.
Figure 5 shows an absorption spectrum of the fluorescent substance obtained in Example 2.

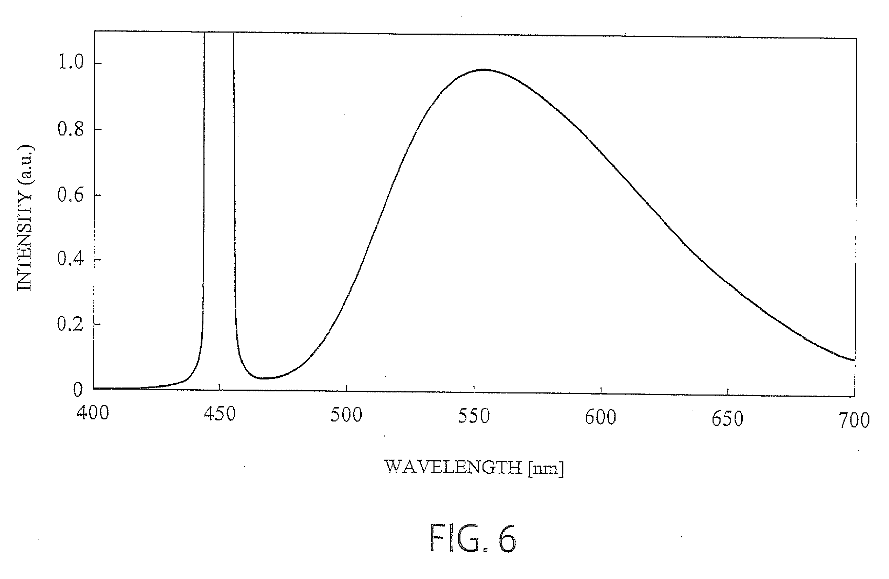

Figure 6 shows an emission spectrum of the fluorescent substance obtained in Example 3.

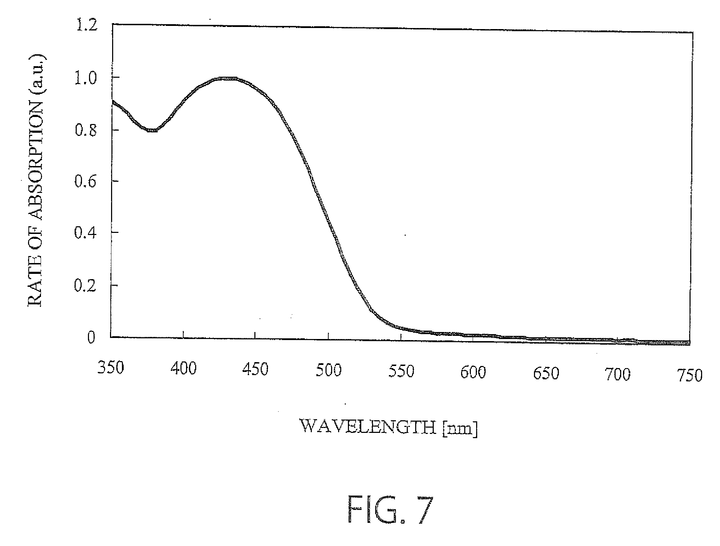

Figure 7 shows an absorption spectrum of the fluorescent substance obtained in Example 4.

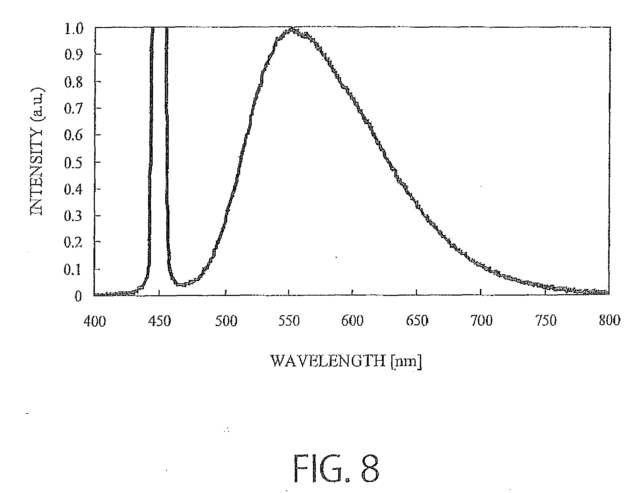

Figure 8 shows an emission spectrum of the fluorescent substance obtained in Comparative example 2.
Figure 9 shows a relation between the composition and the rate of absorption at the emission peak wavelength.

### DETAILED DESCRIPTION

Embodiments will now be explained with reference to the accompanying drawings.

### Yellow light-emitting fluorescent substance

A fluorescent substance according to the embodiment of the present invention represented by the following formula (1):

(M₁-ₓREₓ)_{2y}Al_{z}Si_{10-z}OᵤN_{w}Clα (1)

in which
M is at least one element selected from the group consisting of Ba, Sr, Ca, Mg, Li, Na and K;
RE is an element selected from the group consisting of Ce, Tb, Eu and Mn; and
x, y, z, u, w and α are numbers satisfying the conditions of
0<x≤1,
0.8≤y≤1.1,
2≤z≤3.5,
0<u≤1,
1.8≤z-u,
13≤u+w≤15, and
0<α≤0.0017, respectively
wherein said fluorexcent substance emits luminescence with a peak in the wavelength range of 500 to 600 nm under excitation by light in the wavelength range of 250 to 500 nm.

The yellow light-emitting fluorescent substance is characterized by having a particular composition and by emitting luminescence with a peak in the wavelength range of 500 to 600 nm under excitation by light in the wavelength range of 250 to 500 nm. The following describes this fluorescent substance.

The fluorescent substance according to the embodiment of the present disclosure is represented by the following formula (1): (M₁₋ₓREₓ)_{2y}Al_{z}Si_{10-z}OᵤN_{w}Cl_{α} (1)
in which
M is at least one element selected from the group consisting of Ba, Sr, Ca, Mg, Li, Na and K;
RE is an element selected from the group consisting of Ce, Tb, Eu and Mn; and
x, y, z, u, w and α are numbers satisfying the conditions of
0<x≤1,
0.8≤y≤1.1,
2≤z≤3.5,
0<u≤1,
1.8≤z-u,
13≤u+w≤15, and
0<α≤0.0017, respectively; and is generally categorized into a kind of SiAION phosphor. This fluorescent substance emits luminescence with a peak in the wavelength range of 500 to 600 nm when excited by light in the wavelength range of 250 to 500 nm, and hence is a yellow light-emitting phosphor. The basic crystal structure of the fluorescent substance is essentially the same as (Sr,Ce)₂Si₇Al₃ON₁₃.

In the formula (1), M is at least one element selected from the group consisting of Ba, Sr, Ca, Mg, Li, Na and K. Among them, Sr is most preferred. The metal element M may be a single element, but two or more elements can be used in combination as the metal element M. An M-containing compound used as one of the materials is preferably nitride or carbide.

The metal element RE functions as an emission center of the fluorescent substance. Specifically, the fluorescent substance according to the embodiment has a crystal structure basically comprising the elements M, Al, Si, O and N, but the element M is partly replaced with the emission center element RE. The element RE is selected from the group consisting of Ce, Tb, Eu, and Mn. Two or more of them can be used in combination. Among them, Ce is most preferred because it enables the fluorescent substance to emit yellow luminescence in a favorable wavelength range.

The fluorescent substance according to the embodiment further contains Al and Si, which may be partly replaced with analogous elements as long as they impair the effect of the present embodiment. Specifically, Si may be partly replaced with Ge, Sn, Ti, Zr or Hf, and Al may be partly replaced with B, Ga, In, Sc, Y, La, Gd or Lu.

Further, the fluorescent substance according to the embodiment has specific composition ratios. In the formula (1), the ratios represented by x, y, z, u and w need to satisfy the following particular conditions: that is,
0<x≤1, preferably 0.001≤x≤0.5;
0.8≤y≤1.1, preferably 0.85≤y≤1.06;
2≤z≤3.5, preferably 2.5≤z≤3.3;
0<u≤1, preferably 0.001≤u≤0.8;
1.8≤z-u, preferably 2.0≤z-u;
13≤u+w≤15, preferably 13.2≤u+w≤14.2; and
0<α≤0.0017, preferably 0.0002≤α≤0.0012; respectively.

The fluorescent substance can emit luminescence if the metal element M is at least partly replaced with the emission center element RE. However, if 0.1 mol% or more of the metal element M is replaced with the element RE (that is, if x is 0.001 or more), the fluorescent substance can have sufficient luminous efficiency. The metal element M may be completely replaced with RE (that is, x may be 1), but the replacement ratio with Ce is preferably 50 mol% or less (that is, x is preferably 0.5 or less) so as to avoid decrease of the emission probability (that kind of decrease is often referred to as "concentration quenching"). Accordingly, the number x satisfies the condition of 0<x≤1 preferably, 0.001≤x≤0.5 more preferably.

The number y is preferably 0.8 or more, further preferably 0.85 or more, so as to avoid formation of crystal defects and to prevent decrease of the efficiency. On the other hand, however, the number y is preferably 1.1 or less, further preferably 1.06 or less so that excess of the alkaline earth metal may not deposit in the form of a variant phase to decrease the luminous efficiency. Accordingly, the number y satisfies the condition of 0.8≤x≤1.1 preferably, 0.85≤x≤1.06 more preferably.

The number z is preferably 2 or more, further preferably 2.5 or more so that excess Si may not deposit in the form of a variant phase to decrease the luminous efficiency. On the other hand, however, if it is more than 3.5, excess Al may deposit in the form of a variant phase to decrease the luminous efficiency. The number z is hence preferably 3.5 or less, further preferably 3.3 or less. Accordingly, the number z satisfies the condition of 2≤z≤3.5 preferably, 2.5≤z≤3.3 more preferably.

The number u is preferably 1 or less, further preferably 0.8 or less so that crystal defects may not increase to lower the luminous efficiency. The fluorescent substance preferably has a high rate of absorption of blue light so as to emit luminescence very efficiently when excited by blue light. For the purpose of that, it is necessary to red-shift the absorption spectrum of the fluorescent substance and hence the number u is preferably 0.5 or less. That is because the emission and absorption spectra become both red-shifted in accordance with decrease of the number u. The 5d-orbitals for excited states of free Ce ion are fivefold degenerate. However, if the Ce ion constitutes a crystal, the crystal field affects the electronic state of Ce ion to resolve the degeneracy. The stronger the crystal field is, the more the 5d-orbitals are split and accordingly the more the lowest 5d energy level comes down. As a result, the excitation energy is reduced and hence blue light tends to become more absorbed. In the formula (1), the smaller the number u is, the more nitrogen atoms are combined with the Ce ion and accordingly the more the crystal field is enhanced. Consequently, it becomes possible to excite the fluorescent substance even by light of low energy, namely, even by blue light. For this reason, it is preferred for the number u to be small. On the other hand, however, the number u is preferably 0.001 or more so as to maintain the desired crystal structure and to keep properly the wavelength of the emission spectrum. Accordingly, the number u satisfies the condition of 0<u≤1 preferably, 0.001≤u≤0.8 more preferably.

The value of z-u is preferably 1.8 or more, further preferably 2.0 or more so that the fluorescent substance of the embodiment can retain the desired crystal structure and also so that variant phases may not be formed in the production process of the fluorescent substance. For the same reasons, the value of u+w satisfies the condition of 13:≤u+w≤15 preferably, 13.2≤u+w≤14.2 preferably.

The fluorescent substance according to the embodiment is partly characterized by containing chlorine as an element constituting the crystal. If chlorine is gradually incorporated into the fluorescent substance containing no chlorine, the rate of absorption at the emission peak wavelength gradually decreases according as the amount of chlorine increases in the fluorescent substance. However, if the chlorine amount further increases to more than a certain amount, the rate of absorption tends to increase by contraries. This means that the matrix absorption, which is a factor of lowering the luminous efficiency, can be kept low if the chlorine amount is within a particular range. Accordingly, in the fluorescent substance represented by the formula (1), the number α satisfies the condition of 0<α≤0.0017 preferably, 0.0002≤α≤0.0012 more preferably. As a result of that, the fluorescent substance according to the embodiment can have excellent luminescent properties.

It is not clear whether or not the chlorine is completely included in the crystal structure of the fluorescent substance according to the embodiment. Specifically, it can be presumed that the chlorine may be included as a monovalent ion replacing an anion such as oxygen or nitrogen in the fluorescent substance. On the other hand, however, it can be also presumed that the chlorine may be independent of the crystal structure but may be attached onto the crystal in the form of a simple substance or a compound. Anyway, the formula (1) corresponds to an element composition determined by the elemental analysis.

The elemental analysis of the fluorescent substance according to the embodiment can be carried out in any known manner. For example, it can be performed in the following manners.

The elements M, Si, Al and RE can be analyzed, for example, by inductively coupled plasma emission spectroscopy (which is often referred to as "ICP emission spectroscopy"). Specifically, the sample oxynitride phosphor is weighed out in a platinum crucible, and decomposed by alkali fusion. Thereafter, an internal standard element Y is added therein to prepare a sample solution, which is then analyzed by ICP emission spectroscopy. As the apparatus for analyzing the elements M, Si and RE, an ICP emission spectrophotometer Model SPS-3520UV4000 ([trademark], manufactured by SII Nano Technology Inc.) can be used, for example.

The elements O and N can be analyzed, for example, by inert gas fusion method. Specifically, the sample oxynitride phosphor is melted by heating in a graphite crucible, and O contained in the sample is converted into CO by inert gas conveying. Further, the formed CO is oxidized into CO₂, which is measured by use of infrared absorption to determine the oxygen content. Successively, after CO₂ is removed, the nitrogen content is measured by thermal conductimetry. As the apparatus, a TC-600 oxygen/nitrogen/hydrogen analyzer ([trademark], manufactured by LECO corporation (U.S.A.)) can be used, for example.

The element Cl can be analyzed by ion chromatography. Specifically, the sample oxynitride phosphor is weighed out in a porcelain boat, and decomposed by heating in an oxygen and water-vapor stream to generate a gas, which is collected in an aqueous solution to prepare a sample solution. The sample solution can be measured with an ion chromatography instrument, such as, DX-120 ion chromatograph ([trademark], manufactured by Nippon Dionex K.K.), to determine the Cl amount.

### Method for producing the yellow light-emitting fluorescent substance

According to an embodiment of the present disclosure, a method for producing the fluorescent substance is partly characterized by controlling the particle sizes of the material mixture, but it is not necessary to prepare particular apparatuses or to perform special operations and hence the production cost is not increased. The following explains the method for producing the fluorescent substance according to an embodiment of the present disclosure.

The fluorescent substance according to the embodiment of the present disclosure can be synthesized from starting materials, such as, nitride or carbide of the element M; nitride, oxide or carbide of Al and Si; and chloride, oxide, nitride or carbonate of the emission center element RE. For example, in the case where a phosphor containing Sr and Ce as the elements M and RE, respectively, is intended to be produced, Sr₃N₂, AIN, Si₃N₄ and CeCl₃ can be used as the starting materials. The material Sr₃N₂ may be replaced with Ca₃N₂, Ba₃N₂, Sr₂N, SrN or the like or a mixture thereof. In addition, containing chlorine is one of the characteristics of the fluorescent substance according to the embodiment. The chlorine can be introduced in the form of chlorine-containing compounds of the above metal elements, such as, chlorides and chlorates thereof. In another way, chlorine gas or hydrochloric gas may be introduced into the firing atmosphere, so as to incorporate the chlorine into the fluorescent substance. In the case where the chlorine is introduced in the form of chlorine-containing compounds, the chlorine amount in the resultant fluorescent substance can be controlled by blending ratio of the materials. Further, when the materials in the form of powders are mixed and fired to produce the fluorescent substance, it is also possible to control the resultant chlorine amount by controlling gases, such as chlorine gas, which are liable to volatilize away from the material mixture. Among the above, it is easy to introduce the chlorine in the form of chloride of RE. The materials are so weighed out and mixed that the desired composition can be obtained, and then after pulverized if necessary, the powdery mixture is fired to produce the aimed fluorescent substance.

In the firing procedure, the powdery material mixture is generally laid in a container, such as a crucible, and then fired in a heating furnace or the like. The crucible is preferably filled with the material mixture in a sufficient amount, specifically, in an amount corresponding to 80% to 90% of the crucible volume. Further, the material mixture is preferably tapped so that the crucible may be densely packed. It is also preferred to put the lid on the packed crucible. Furthermore, it is still also preferred to place the crucible in an outer container such as another crucible. Those are preferred for the purpose of preventing chlorine from volatilizing away to decrease the chlorine amount. In addition, if the material mixture is doubly surrounded with the two crucibles, the whole heat capacity is increased to improve heat uniformity and hence it can be expected to obtain a sample having favorable luminescent properties.

The material mixture is preferably fired under a pressure not less than the atmospheric pressure. If silicon nitride is used as one of the materials, the pressure is further preferably 5 atm or more so as to prevent the silicon nitride from decomposing at a high temperature. The firing temperature is preferably 1500 to 2000°C, more preferably 1700 to 2000°C. If the temperature is lower than 1500°C, it is often difficult to produce the aimed fluorescent substance. On the other hand, if it is higher than 2000°C, it is feared that the materials or product may sublimate. Further, if the materials contain nitrides, it is preferred to fire them in a N₂ atmosphere because they tend to be oxidized. However, they may be fired in a N₂/H₂ mixed atmosphere. As described above, the oxygen content in the atmosphere should be strictly controlled.

After the firing procedure, the obtained powder is subjected to after-treatments such as washing, if necessary, to obtain a fluorescent substance of the present embodiment.

The washing can be carried out, for example, by use of pure water or acid.

### Light-emitting device

The fluorescent substance according to the embodiment of the present disclosure can be combined with a light-emitting element capable of exciting it, to produce a light-emitting device.

The light-emitting device according to the embodiment of the present disclosure comprises a combination of a light-emitting element serving as an excitation light source and the above yellow-light emitting fluorescent substance (Y), which emits luminescence under excitation by light radiated from the light-emitting element. Consequently, the light-emitting device gives off light synthesized from the excitation light radiated from the light-emitting element and the luminescence emitted from the yellow-light emitting fluorescent substance.

The light-emitting element, such as an LED element, is properly selected in view of the combination with the used fluorescent substance. Specifically, the light-emitting element needs to radiate light capable of exciting the used fluorescent substance. Further, in the case where it is preferred for the devise to give off white light, the light-emitting element preferably radiates light of wavelength complementary to the luminescence emitted from the fluorescent substance

In consideration of the above, in producing the light-emitting device comprising a yellow-light emitting phosphor as the fluorescent substance, the light-emitting element is so selected as to radiate light in the wavelength range of 250 to 500 nm.

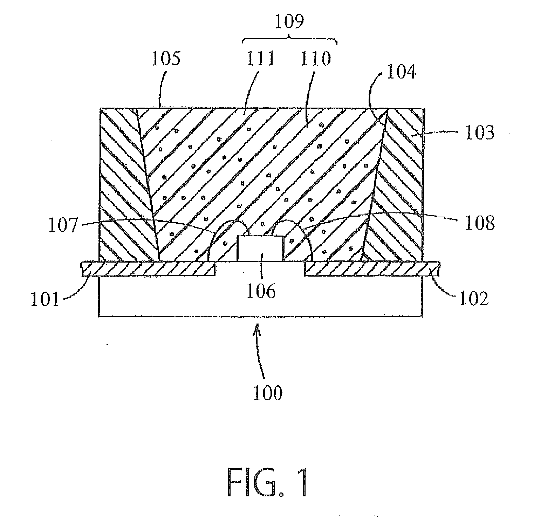

The light-emitting device according to the embodiment of the present disclosure can be in any form of known devices. Figure 1 shows a vertical sectional view schematically illustrating a light-emitting device according to an embodiment of the present disclosure.

In the light-emitting device shown in Figure 1, the light-emitting element 100 comprises leads 101 and 102, which are formed as a part of a lead frame, and also comprises a resin member 103, which is formed by integral molding with the lead frame. The resin member 103 has a concavity 105 in which the top opening is larger than the bottom. The inside wall of the concavity 105 is coated with a reflective surface 104.

At the center of the nearly circular bottom of the concavity 105, there is a light-emitting element 106 mounted with Ag paste or the like. Examples of the light-emitting element 106 include light-emitting diodes or laser diodes, such as a GaN type semiconductor light-emitting element. The light-emitting element is so selected as to radiate light of proper wavelength according to the combination with the fluorescent substance. The electrodes (not shown) of the light-emitting element 106 are connected to the leads 101 and 102 by way of bonding wires 107 and 108 made of Au or the like, respectively. The positions of the leads 101 and 102 can be adequately modified.

In the luminescent layer 109, the fluorescent substance according to the embodiment of the present disclosure is dispersed or precipitated in a resin layer 111 made of, for example, silicone resin in an amount of 5 to 50 wt%. The fluorescent substance according to the embodiment comprises an oxynitride matrix having high covalency, and hence is generally hydrophobic enough to have very good compatibility with the resin. Accordingly, scattering at the interface between the resin and the fluorescent substance is prevented sufficiently to improve the light-extraction efficiency.

The light-emitting element 106 may be of a flip chip type in which the n- and p-electrodes are placed on the same plane. This element can avoid troubles concerning the wires, such as disconnection or dislocation of the wires and light-absorption by the wires. Accordingly, that element enables to obtain a semiconductor light-emitting device excellent both in reliability and in luminance. Further, it is also possible to use a light-emitting element 106 having an n-type substrate so as to produce a light-emitting device constituted as described below. Specifically, in that device, an n-electrode is formed on the back surface of the n-type substrate while a p-electrode is formed on the top surface of a semiconductor layer on the substrate. The n- or p-electrode is mounted on one of the leads, and the p- or n-electrode is connected to the other lead by way of a wire. The size and kind of the light-emitting element 106 and the dimension and shape of the concavity 105 can be properly changed.

The light-emitting device according to an embodiment of the present disclosure is not restricted to the package cup-type shown in Figure 1, and can be freely modified. For example, even if the fluorescent substance of the embodiment is used in a shell-type or surface-mount type light-emitting device, the same effect can be obtained.

Embodiments of the present disclosure are further explained in detail by use of the following examples, but they by no means restrict the embodiments.

### Examples 1 to 5 and Comparative examples 1 and 2

As the starting materials, Sr₃N₂, CeCl₃, Si₃N₄ and AIN were prepared. They were weighed out and mixed, and the blended amounts in each example were shown in Table 1. Each material mixture was laid in a BN crucible and then fired at 1800°C for 15 hours under 7.5 atm in a N₂ atmosphere, to obtain a fluorescent substance.

While singly surrounded with only one crucible (with a lid) in Comparative example 1, the material mixture was doubly surrounded with two crucibles (with lids) in each of Examples 1 to 3. Since doubly sealed in Examples 1 to 3, the materials could be fired under the condition where volatile substances such as chlorine and chlorides were hardly evaporated away. Further, while immediately fired in Comparative example 1, the powdery material mixture laid in the crucible was tapped 100 times before fired in each Example. As a result of tapping, the material mixture of each Example was packed in the crucible in such an amount that the mixture reached up to about eight-tenths to nine-tenths of the inside wall in the crucible. The tapping procedure thus increased the packing density enough to achieve the condition where volatile substances such as chlorine and chlorides were hardly evaporated away. The blended composition of Example 1 was the same as that of Example 2, but the particle size of Sr₃N₂ was changed. Specifically, the particle size of Sr₃N₂ in Example 1 was larger than that in Example 2. Since having the lowest melting point of the materials, CeCl₃ begins to change the state first when heated. Following that, the other materials of nitrides begin to change their states. The materials in the form of smaller particles are more reactive than those in larger particles, and accordingly they undergo the reaction so faster that the chlorine can be more easily incorporated into the crystal.

In contrast, the materials in the form of larger particles undergo the reaction more slowly, so that the chlorine tends to volatilize away in the course of the reaction. Consequently, the chloride is presumed to be less incorporated into the crystal.

**Table 1**

| | Blended composition | Sr₃N₂ | CeCl₃ | Si₃N₄ | AlN |
|---|---|---|---|---|---|
| Com. 1 | (Sr_{0.98}Ce_{0.02})₂Si_{7.5}Al_{2.5}N₁₄ | 2.902 | 0.148 | 5.262 | 1.537 |
| Ex. 1 | (Sr_{0.98}Ce_{0.02})_{2.1}Si_{7.5}Al_{2.5}N₁₄ | 3.047 | 0.155 | 5.262 | 1.537 |
| Ex. 2 | (Sr_{0.98}Ce_{0.02})_{2.1}Si_{7.5}Al_{2.5}N₁₄ | 3.047 | 0.155 | 5.262 | 1.537 |
| Ex. 3 | (Sr_{0.975}Ce_{0.025})₂Si_{7.5}Al_{2.5}N₁₄ | 3.031 | 0.194 | 5.262 | 1.537 |
| Com. 2 | (Sr_{0.97}Ce_{0.03})_{2.1}Si_{7.5}Al_{2.5}N₁₄ | 3.016 | 0.233 | 5.262 | 1.537 |

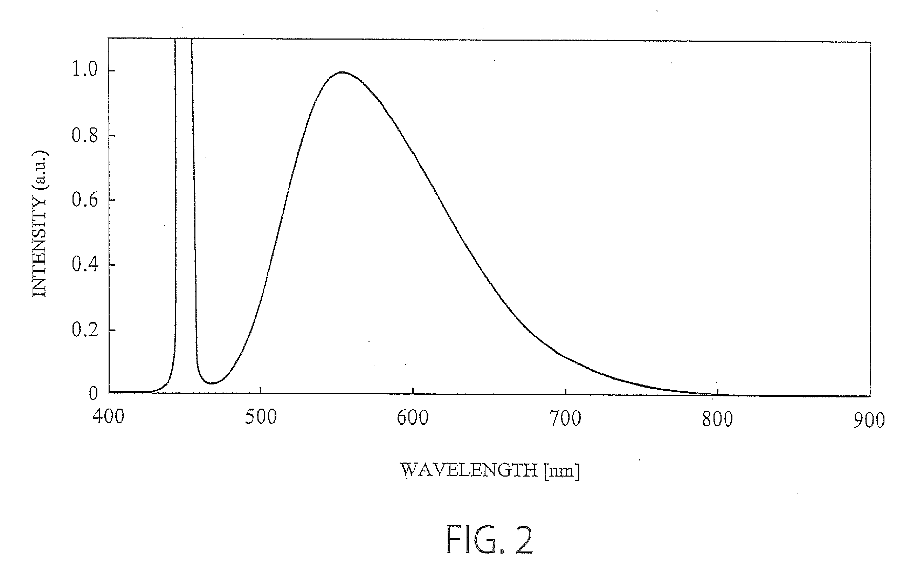

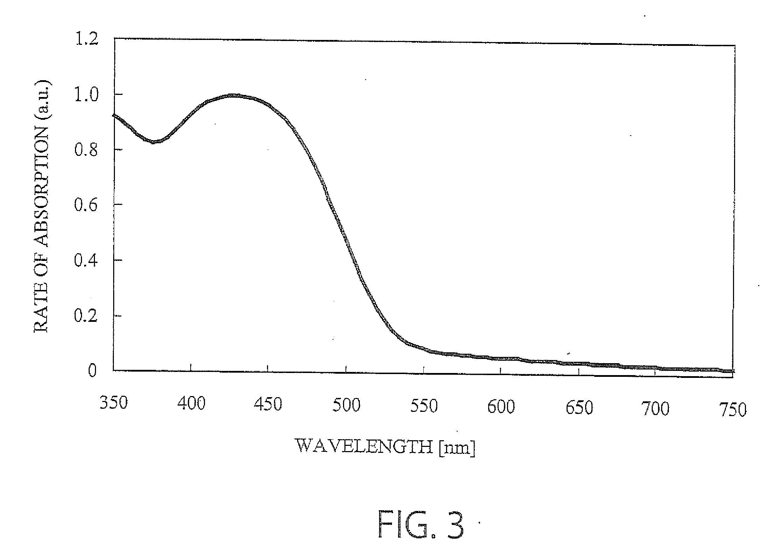

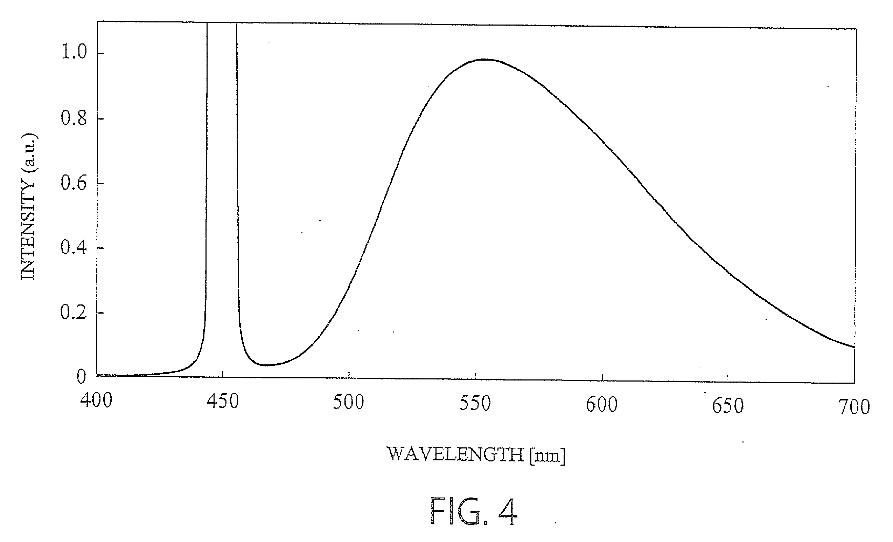

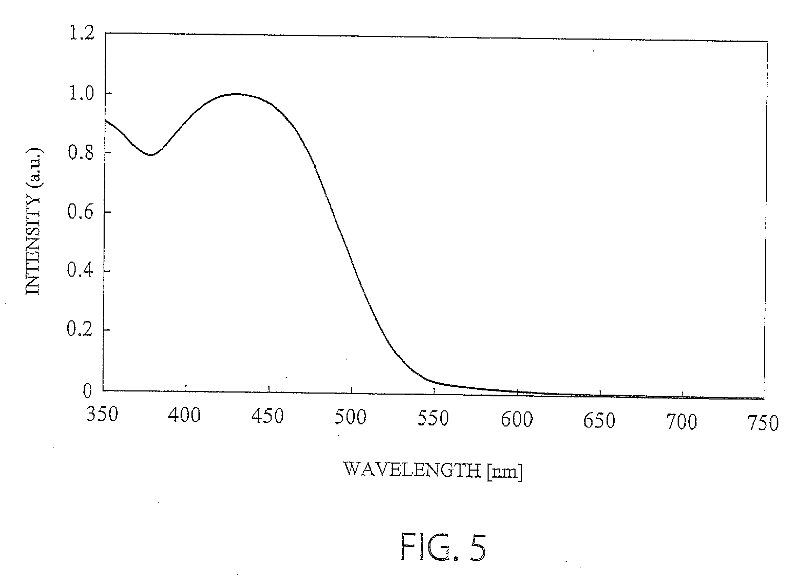

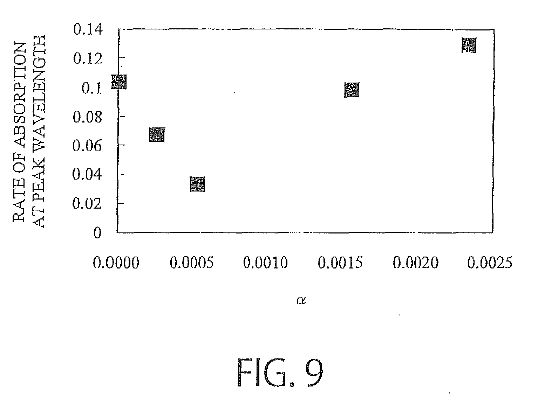

The composition of each obtained fluorescent substance was analyzed by ICP spectroscopy. Further, the emission and absorption spectra of each fluorescent substance were measured with a fluorescence spectrophotometer (C9920-02G absolute quantum yield measurement system [trademark], manufactured by Hamamatsu Photonics K.K.). Figures 2 and 3 show the emission and absorption spectra in Example 1, respectively. Figures 4 and 5 show the emission and absorption spectra in Example 2, respectively. Moreover, Table 2 and Figure 9 show a relation between the composition and the rate of absorption at the emission peak wavelength.

**Table 2**

| | Composition | Rate of absorption at the emission peak wavelength |
|---|---|---|
| Com.1 | (Sr_{0.945}Ce_{0.0195})₂Si_{7.5}Al_{2.5}O_{0.33}N_{13.36} | 0.103 |
| Ex. 1 | (Sr_{0.914}Ce_{0.0195})_{2.1}Si_{7.48}Al_{2.52}O_{0.41}N_{13.45}Cl_{0.00026} | 0.067 |
| Ex. 2 | (Sr_{0.905}Ce_{0.0195})_{2.1}Si_{7.47}Al_{2.53}O_{0.36}N_{13.74}Cl_{0.00052} | 0.033 |
| Ex. 3 | (Sr_{0.955}Ce_{0.026})₂Si_{7.49}Al_{2.51}O_{0.39}N_{13.52}Cl_{0.00156} | 0.097 |
| Com. 2 | (Sr₀.₉Ce_{0.031})_{2.1}Si_{7.5}Al_{2.5}O_{0.36}N_{13.5}Cl_{0.00234} | 0.128 |

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fail within the scope and spirit of the inventions.

## Claims

1. A fluorescent substance represented by the following formula (1):
(M₁₋ₓREₓ)_{2y}Al_{z}Si_{10-z}OᵤN_{w}Cl_{α} (1)
in which
M is at least one element selected from the group consisting of Ba, Sr, Ca, Mg, Li, Na and K;
RE is an element selected from the group consisting of Ce, Tb, Eu and Mn; and
x, y, z, u, w and α are numbers satisfying the conditions of
0<x≤1,
0.8≤y≤1.1,
2≤z≤3.5,
0<u≤1,
1.8≤z-u,
13≤u+w≤15, and
O<α≤0.0017, respectively
wherein said fluorexcent substance emits luminescence with a peak in the wavelength range of 500 to 600 nm under excitation by light in the wavelength range of 250 to 500 nm.

2. The fluorescent substance according to claim 1, wherein said element RE is Ce.

3. The fluorescent substance according to claim 1, wherein said element M is Sr.

4. A method for producing the fluorescent substance according to claim 1, including the step in which
a material mixture containing
nitride or carbide of M,
nitride, oxide or carbide of Al,
nitride, oxide or carbide of Si, and
chloride, oxide, nitride or carbonate of RE
is fired at a temperature in the range of 1500 to 2000°C.

5. The method according to claim 4, wherein said step for firing is carried out under a pressure not less than the atmospheric pressure.

6. The method according to claim 4, further including the step in which the obtained powder is washed after said step for firing.

7. The method according to claim 4, wherein said material mixture contains chloride of RE.

8. A light-emitting device comprising
a light-emitting element (S1) radiating light in the wavelength range of 250 to 500 nm, and
the fluorescent substance (Y) according to claim 1.

9. A light-emitting device comprising
a light-emitting element (S2) radiating light in the wavelength range of 250 to 430 nm,
the fluorescent substance (Y) according to claim 1, being excited by the light from said light-emitting element S2, and
a fluorescent substance (B) which emits luminescence with a peak in the wavelength range of 400 to 490 nm under excitation by light radiated from said light-emitting element (S2).
